Europäisches Patentamt

European Patent Office

Office européen des brevets

(19)

(11) Veröffentlichungsnummer: **0 061 518**

**A1**

(12) # EUROPÄISCHE PATENTANMELDUNG

(21) Anmeldenummer: **81108376.5**

(22) Anmeldetag: **15.10.81**

(51) Int. Cl.³: **H 01 L 23/36**
**H 01 L 23/44**

(30) Priorität: **19.03.81 DE 3110806**

(43) Veröffentlichungstag der Anmeldung:
**06.10.82 Patentblatt 82/40**

(84) Benannte Vertragsstaaten:
**AT BE FR GB IT NL**

(71) Anmelder: **SIEMENS AKTIENGESELLSCHAFT Berlin und München**
**Postfach 22 02 61**
**D-8000 München 22(DE)**

(72) Erfinder: **Hermann, Rudolf**
**Milbertshofenerstrasse 131**
**D-8000 München 40(DE)**

(54) **Wärmeableitungsvorrichtung für gehäuselos montierte elektronische Schaltungen.**

(57) Die Erfindung bezieht sich auf eine Wärmeableitungsvorrichtung für gehäuselos montierte elektronische Schaltungen mit hoher Verlustleistungsdichte für gasförmige oder flüssige Kühlmedien. Zur Erhöhung der Leistungsfähigkeit von elektronischen Einbausystemen werden auf Epoxid-Leiterplatten großintegrierte Bausteine in geringem Abstand gehäuselos montiert. Dabei soll die auftretende Verlustleistungswärme wirksam abgeführt werden. Die Erfindung sieht hierzu eine gut wärmeleitende Trägerplatte 1 vor, die auf der einen Seite zur Aufnahme von einem oder mehreren integrierten Schaltkreisen 2 dient und auf der anderen Seite mit einzeln angeordneten gut wärmeleitenden Stiften 3 versehen ist, die durch entsprechende Bohrungen 4 der Leiterplatte 5 hindurchgesteckt werden können und auf der Bauteile abgewandten Leiterplattenseite in das Kühlmedium, das flüssig luft- oder gasförmig sein kann, hineinragen. Dadurch erhält man extrem niedrige Chiptemperaturen.

0061518

SIEMENS AKTIENGESELLSCHAFT
Berlin und München

Unser Zeichen
VPA 81 P 2012 E

Wärmeableitungsvorrichtung

Die Erfindung betrifft eine Wärmeableitungsvorrichtung für gehäuselos montierte elektronische Schaltungen mit hoher Verlustleistungsdichte für luft-, gasförmige oder flüssige Kühlmedien.

Zur Erhöhung der Leistungsfähigkeit von elektronischen Einbausystemen werden auf Epoxid-Leiterplatten großintegrierte Bausteine in geringem Abstand gehäuselos montiert.

Die bisher bei herkömmlichen Bausteingehäusen übliche Abfuhr der Verlustleistungswärme durch Wärmeleitung in das Gehäuse und weiter durch Konvention an vorbeiströmende Kühlluft ist in dieser Anordnung nicht mehr möglich. Statt dessen muß die Verlustleistungswärme durch geeignete Kühlsysteme von der bauteileabgewandten Baugruppenseite abgeführt werden.

Die bisher üblichen Verfahren der Wärmeabfuhr beruhen darauf, daß durch die Chipmontage bedingt, die vom Chip erzeugte Verlustleistungswärme sich durch Wärmeleitung über das ganze Bausteingehäuse und zusätzlich über die Anschlußpins auch in die Leiterplatte verteilen bzw. ausbreiten kann.

Somit ist eine große wärmeabgebende Fläche gegeben, von der durch natürliche oder erzwungene Konvektion mittels Luftkühlung eine relativ gute Abfuhr der Verlustleistungswärme an das umgebende Kühlmedium ermöglicht wird.

Bei entsprechend hohen Verlustleistungen und gleichzeitiger Forderung nach niedrigen Chip-Temperaturen kann durch zusätzliches Aufbringen eines großflächigen Kühlkörpers auf das Gehäuse eine weitere Verbesserung der Wärmeabfuhr

Zk 1 Fdl/3. 2. 1981

0061518
VPA 81 P 2012 E

erzielt werden.

Bei der oben aufgeführten Einbautechnik der Chips auf die Baugruppen ist aus technologischen Gründen (kein Zugang zu den Chips mehr möglich, mechanische Belastung für den Chip zu groß), die herkömmliche Abfuhr der Verlustleistungswärme von den Bauteilen nicht mehr möglich.

Aufgabe der vorliegenden Erfindung ist es, eine Wärmeableitungsvorrichtung zu schaffen, die auch bei großintegrierten Bausteinen und hoher Packungsdichte eine ausreichende Wärmeableitung gewährleistet.

Zur Lösung dieser Aufgabe wird die Wärmeableitungsvorrichtung gemäß der Erfindung derart ausgebildet, daß eine gut wärmeleitende Trägerplatte auf der einen Seite mit einzeln angeordneten, gut wärmeleitenden Stiften versehen ist, die durch entsprechende Bohrungen einer Leiterplatte hindurchsteckbar sind und die auf der Bauteile abgewandten Seite in ein Kühlmedium hineinragen und daß auf der anderen Seite der Trägerplatte mindestens ein integrierter Schaltkreis gut wärmekontaktierend aufgebracht und mit den Leiterbahnen der Leiterplatte z.B. durch Wire-bonding oder Filmmontage kontaktiert ist.

Durch diese Maßnahmen wird eine gute Verwirbelung des Kühlmediums und ein optimaler konvektiver Wärmeübergang erreicht.

Die durch die Leiterplatte hindurchgesteckte Kühlkörperanordnung kann z. B. durch Löten oder Kleben mechanisch fest mit der Leiterplatte verbunden werden.
Hierdurch wird gleichzeitig die Chipseite gegen das Kühlmedium auf der chipabgewandten Seite abgedichtet.

Die Stifte der Wärmeableitungsvorrichtung können in ihren Längs- und Querabmessungen im Hinblick auf ein optimales Kühlverhalten und dem zur Verfügung stehenden Einbauraum unterschiedlich dimensioniert sein.

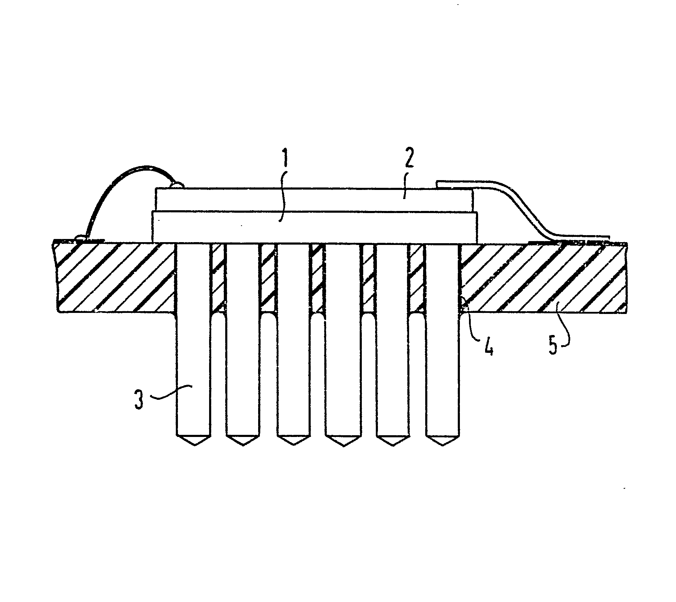

Anhand des Ausführungsbeispieles nach der Figur wird die Erfindung näher erläutert.

Die Kühlanordnung besteht aus einer gut wärmeleitenden Trägerplatte 1, die auf der einen Seite zur Aufnahme von einem oder mehreren integrierten Schaltkreisen (Chip 2) dient und auf der anderen Seite mit einzeln angeordneten gut wärmeleitenden Stiften 3 versehen ist, die durch entsprechende Bohrungen 4 der Leiterplatte 5 hindurchgesteckt werden können und auf der Bauteile abgewandten Leiterplattenseite in das Kühlmedium hineinragen. Je nach Baugruppenaufbau, Größe und Rasterteilung der Leiterplattendurchkontaktierungen des zur Verfügung stehenden Einbauraums und der Wahl des Kühlmediums Luft, Gas oder Flüssigkeit können die Stifte den Erfordernissen der Kühlung entsprechend unterschiedlich lang und mit unterschiedlichem Querschnitt ausgeformt sein. Auf die Trägerplatte können der oder die integrierten Schaltkreise durch bekannte Montageverfahren wie Löten oder Kleben befestigt werden und die herkömmlichen Verbindungstechniken mit den Bausteinanschlüssen von Chips 2 und Leiterplatte 5 sicher kontaktiert werden.

Diese Kühlanordnung erlaubt einen raschen Transport der Verlustleistung durch die Leiterplatte 1 hindurch auf die bausteinabgewandte Leiterplattenseite und eine gute konvektive Wärmeabfuhr an ein vorbeiströmendes Kühlmedium.

1 Figure
2 Patentansprüche

0061518

-4-

Patentansprüche

1. Wärmeableitungsvorrichtung für gehäuselos montierte elektronische Schaltungen mit hoher Verlustleistungsdichte für gasförmige oder flüssige Kühlmedien, d a - d u r c h  g e k e n n z e i c h n e t, daß eine gut wärmeleitende Trägerplatte (1) auf der einen Seite mit einzeln angeordneten, gut wärmeleitenden Stiften (3) versehen ist, die durch entsprechende Bohrungen (4) einer Leiterplatte (5) hindurchsteckbar sind und die auf der Bauteile abgewandten Seite in ein Kühlmedium hineinragen und daß auf der anderen Seite der Trägerplatte mindestens ein integrierter Schaltkreis gut wärmekontaktierend aufgebracht und mit den Leiterbahnen der Leiterplatte (5) kontaktiert ist.

2. Wärmeableitungsvorrichtung nach Anspruch 1, d a d u r c h  g e k e n n z e i c h n e t, daß die Stifte in ihren Längs- und Querabmessungen und in ihrer Anzahl im Hinblick auf ein optimales Kühlverhalten unterschiedlich dimensioniert sind.

**EUROPÄISCHER RECHERCHENBERICHT**

Europäisches
Patentamt

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| X | IBM TECHNICAL DISCLOSURE BULLETIN, Band 20, Nr. 7, Dezember 1977, Seiten 2637-2638, New York, USA R.A. FOSTER et al.: "Thermally enhanced package for semiconductor devices" * Figur 1; Seite 2637, Absatz 2 * | 1 | H 01 L 23/36 H 01 L 23/44 |
| | --- | | |
| X | IBM TECHNICAL DISCLOSURE BULLETIN, Band 17, Nr. 7, Dezember 1974, Seiten 1929-1930, New York, USA R.F. BOEHM et al.: "Module power distribution and cooling unit" * Figur; Seite 1929, Absatz 3 * | 1 | |
| | ----- | | |

RECHERCHIERTE SACHGEBIETE (Int. Cl. 3)

H 01 L

Der vorliegende Recherchenbericht wurde für alle Patentansprüche erstellt.

| Recherchenort DEN HAAG | Abschlußdatum der Recherche 06-07-1982 | Prüfer DE RAEVE R.A.L. |
|---|---|---|